(19) Europäisches Patentamt / European Patent Office / Office européen des brevets

(11) **EP 4 585 931 B1**

(12) **EUROPEAN PATENT SPECIFICATION**

(45) Date of publication and mention
of the grant of the patent:
**24.06.2026 Bulletin 2026/26**

(21) Application number: **24218079.2**

(22) Date of filing: **06.12.2024**

(51) International Patent Classification (IPC):
**G01R 15/18** *(2006.01)* **G01R 15/20** *(2006.01)*

(52) Cooperative Patent Classification (CPC):
**G01R 15/185; G01R 15/202;** G01R 15/207

(54) **SYSTEMS AND METHOD FOR REDUCING HEAT GENERATION AND POWER CONSUMPTION OF CURRENT SENSORS**

SYSTEME UND VERFAHREN ZUR REDUZIERUNG DER WÄRMEERZEUGUNG UND DES STROMVERBRAUCHS VON STROMSENSOREN

SYSTÈMES ET PROCÉDÉ DE RÉDUCTION DE LA GÉNÉRATION DE CHALEUR ET DE LA CONSOMMATION D'ÉNERGIE DE CAPTEURS DE COURANT

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **10.01.2024 CN 202410041282**

(43) Date of publication of application:
**16.07.2025 Bulletin 2025/29**

(73) Proprietor: **Honeywell International Inc.**
**Charlotte, NC 28202 (US)**

(72) Inventors:
• **HAN, Liansheng**
**Charlotte 28202 (US)**
• **HUANG, Changchang**
**Charlotte 28202 (US)**
• **AI, Lei**
**Charlotte 28202 (US)**
• **WANG, Zhenhao**
**Charlotte 28202 (US)**
• **LIU, Zhi**
**Charlotte 28202 (US)**
• **LI, Yangyang**
**Charlotte 28202 (US)**

(74) Representative: **Haseltine Lake Kempner LLP**
**Cheapside House**
**138 Cheapside**
**London EC2V 6BJ (GB)**

(56) References cited:
**WO-A1-2023/029598 CN-A- 1 046 981**
**CN-U- 212 483 673 US-A1- 2013 106 412**

## Description

### TECHNICAL FIELD

Various embodiments of the present disclosure relate to current sensors, and more particularly to varying operation of current sensors to control heat generation and power consumption.

### BACKGROUND

Current sensors are employed in a variety of industrial and automotive applications. For example, the monitoring of current is essential in terms of safety, performance, and efficiency of electric vehicles. However, current sensors are prone to overheating and high power consumption when used in high current or high voltage applications, such as in electrical vehicles. Applicant has identified many technical challenges and difficulties associated with conventional current sensors.

CN 212 483 673 U discloses a closed-loop Hall current sensor with low power consumption, comprising a magnetic core, a primary wire pierced with the magnetic core, a feedback coil wound with the magnetic core, and a Hall element in the air gap of the magnetic core. The output terminal of the Hall element is grounded after passing through a differential amplifier. A switching element is connected to a microcontroller. The sensor further comprises an AD conversion circuit, the input end of the AD conversion circuit being connected between the feedback coil and the measuring resistor, and the output end of the AD conversion circuit being connected to an output terminal via an isolator.

WO 2023/029598 A1 discloses a low-power intelligent current sensor including a magnetic core, a secondary coil wound with the magnetic core, a magnetic sensor disposed in the magnetic core, and a current detection circuit. The current detection circuit includes a power supply module, a drive module, a microcontroller, a temperature detection module, and a signal input/output interface module. The signal output end of the magnetic sensor is connected to the signal input end of the drive module, and the drive module is respectively connected to the two ends of the secondary coil for power supply. The microcontroller is respectively connected to the power supply module, the drive module, the temperature detection module and the signal input/output interface module. The power supply module is respectively connected to the drive module, the microcontroller, the temperature detection module and the signal input/output. The interface module is connected for power supply, the input end and output end of the signal input/output interface module are respectively connected with the client signal, and the temperature detection module is installed in the current sensor to detect the temperature of the current sensor.

### BRIEF SUMMARY

Various embodiments described herein relate to methods, apparatuses, and systems for controlling a current sensor.

The scope of the present invention is defined by the appended claims.

### BRIEF DESCRIPTION OF THE DRAWINGS

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:

FIG. 1 depicts an example current sensor;

FIG. 2 depicts an example current sensor in accordance with various embodiments of the present disclosure;

FIG. 3A depicts an example continuous mode control signal in accordance with various embodiments of the present disclosure;

FIG. 3B depicts an example pulse mode control signal in accordance with various embodiments of the present disclosure;

FIG. 4A is a block diagram of an example current sensor apparatus in accordance with various embodiments of the present disclosure;

FIG. 4B is a block diagram of an alternative example current sensor apparatus in accordance with various embodiments of the present disclosure;

FIG. 4C is a block diagram of another alternative current sensor apparatus in accordance with various embodiments of the present disclosure;

FIG. 5 is an example flow diagram of an exemplary method for controlling a current sensor in accordance with some example embodiments of the present disclosure;

FIG. 6 depicts an example timing diagram for optimizing power consumption in accordance with some example embodiments of the present disclosure.

FIG. 7 depicts an example timing diagram for optimizing current sensor temperature in accordance with some example embodiments of the present disclosure.

FIG. 8 depicts an example timing diagram for optimizing both power consumption and current sensor temperature in accordance with some example embodiments of the present disclosure.

## DETAILED DESCRIPTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

As used herein, terms such as "front," "rear," "top," etc., are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

A closed-loop current sensor may comprise a current measurement technique that provides galvanic and electrical isolation (e.g., without electrical contact) between a primary circuit (e.g., a measured circuit) and a sensor output for measuring the primary current of the primary circuit.

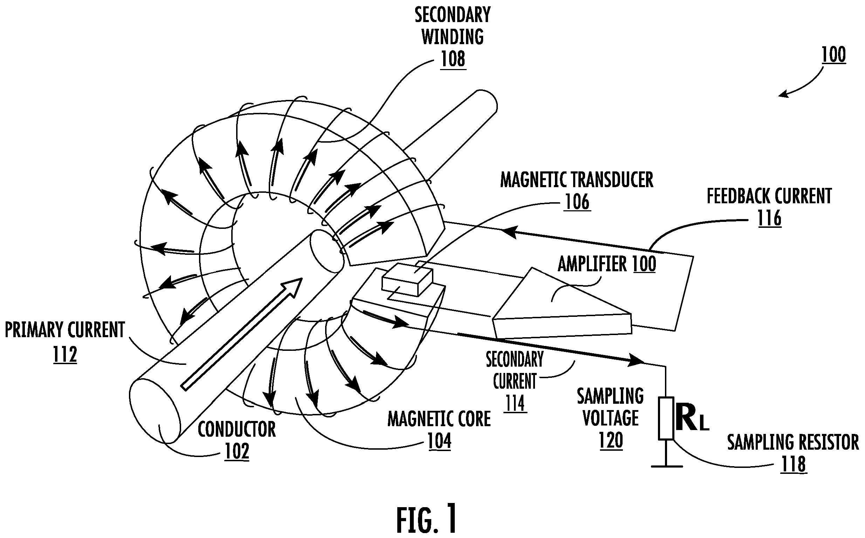

FIG. 1 depicts an example current sensor 100. As depicted in FIG. 1, current sensor 100 comprises a closed-loop current sensor. Current sensor 100 comprises a magnetic core 104 that is wrapped with a secondary winding 108. Current sensor 100 further comprises a magnetic transducer 106 that is configured in an air gap of magnetic core 104. Magnetic transducer 106 is coupled to an amplifier 110. The magnetic transducer 106 is configured to generate a voltage output (e.g., a Hall voltage) in a presence of a magnetic field surrounding the magnetic transducer 106 in the air gap. The magnetic field may be caused by inserting a conductor 102, carrying a primary current 112, inside the magnetic core 104. The voltage output may be based on a magnetic flux density of the magnetic field surrounding the magnetic transducer 106 that is proportional to the primary current 112.

The voltage output generated by magnetic transducer 106 may be amplified by the amplifier 110 and converted to a feedback current 116. The secondary winding 108 is coupled to the amplifier 110 at a first end of the secondary winding 108 and receives the feedback current 116 such that the secondary winding 108 may generate a magnetic field that opposes the magnetic field associated with the primary current 112 thereby generating a secondary current 114 at a second end of the secondary winding 108 such that the following condition is created:

$$I_P N_P = I_S N_S$$

**<u>Equation 1</u>**

where $I_P$ may represent the primary current 112, $I_S$ may represent the secondary current 114, $N_P$ may represent a number of a primary winding associated with the conductor 102, and $N_S$ may represent a number of the secondary winding 108. As such, primary current 112 may be determined based on a derivation of secondary current 114. A sampling resistor 118 comprising a known resistance value is coupled to the second end of the secondary winding 108. The secondary current 114 may be determined by receiving a sampling voltage 120 across the sampling resistor 118 and using Ohm's law (e.g., $V = IR$). Primary current 112 may be determined based on the secondary current 114 using Equation 1.

Heat may be generated at sampling resistor 118 as a by-product of receiving the secondary current 114. The amount of heat generated at sampling resistor 118 may be proportional to the square of the current amperage and the resistance value according to Joule's law. As such, the larger the primary current 112, the larger the secondary current 114 and associated heat output at sampling resistor 118 may be. A larger secondary current 114 may thereby require larger power consumption by amplifier 110 to generate feedback current 116. Overheating and high power consumption are generally parameters that are monitored and desirable to minimize in applications, such as in electrical vehicles.

Various example embodiments of the present disclosure overcome such technical challenges and difficulties in current sensors and provide various technical advancements and improvements. In accordance with various examples of the present disclosure, components of example current sensors for improving current sensor performance are disclosed. In some embodiments, a closed-loop current sensor comprises a switch that is configured to either open or close a circuit of the closed-loop current sensor based on heat and power consumption conditions and requirements. In some embodiments, the switch is configured to operate in either a continuous mode or a pulse mode by, for example, a controller unit based on one or more thresholds and/or one or more optimization targets. In some embodiments, the one or more thresholds comprise a primary current threshold, a temperature threshold, and a primary current frequency threshold. In some embodiments, the one or more optimization targets comprise optimal power consumption regulation, optimal heating regulation, or overall regulation.

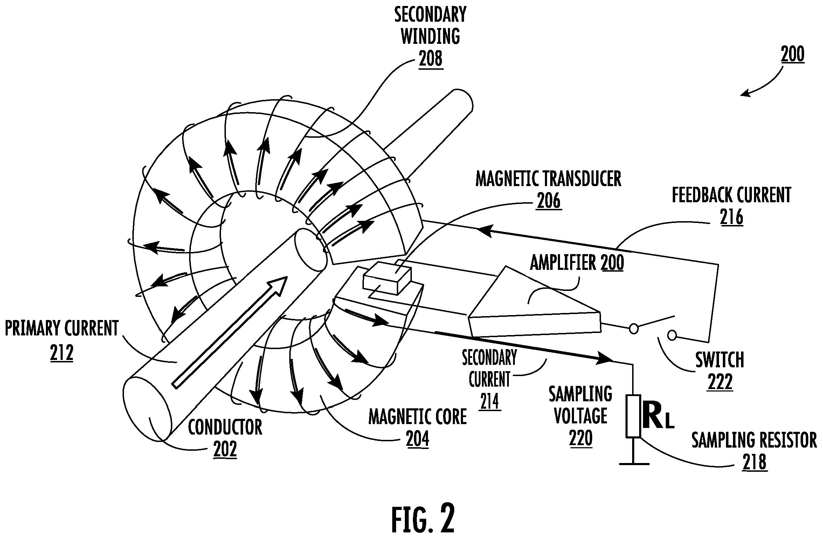

FIG. 2 depicts an example current sensor 200 in accordance with various embodiments of the present disclosure. Current sensor 200 comprises a closed-loop sensor including a magnetic transducer 206 (e.g., a Hall-effect sensor) in an air gap along a core body of a magnetic core 204. The magnetic core 204 may comprise ferromagnetic materials, such as nanocrystalline and ferronickel materials (e.g., a toroid core). In some embodiments, the magnetic core 204 comprises a torus, or colloquially known as a donut or doughnut, shape including a ring portion and an inner void. The inner void of magnetic core 204 may be configured for detection of a primary current 212 carried by a conductor 202 which may produce a magnetic flux detectable by magnetic transducer 206.

The magnetic transducer 206 is coupled to an amplifier 210 (e.g., an operational amplifier). A voltage output (e.g., Hall voltage) may be generated by the magnetic transducer 206 based on a magnetic flux detected by the magnetic transducer. The amplifier 210 may receive the voltage output from the magnetic transducer 216 and generate an amplified voltage signal comprising a feedback current 216. The feedback current 216 may be received at a first end of a secondary winding and driven through the secondary winding 208. The secondary winding 208 may comprise a wire coil that is extended around the core body of the magnetic core 204. In some embodiments, the secondary winding 208 comprises a helical coil of wire wound about an exterior of magnetic core 204. For example, the secondary winding 208 may comprise an $N_s$ number of turns around the magnetic core 204. The secondary winding 208 may comprise a copper wire or any conductor suitable for conducting an electrical current.

The feedback current 216 received by the secondary winding 208 may generate an opposing magnetic field that cancels the magnetic flux created by the primary current 212, thereby resulting in a secondary current 214, at a second end of the secondary winding 208, that is proportional to the primary current 212. A sampling resistor 218 (e.g., a shunt resistor) is coupled to the second end of the secondary winding 208. The secondary current 214 may be determined by receiving a sampling voltage 220 across the sampling resistor 218 and converting the sampling voltage 220 into a digital signal usable to determine a value of the secondary current 214 based on a known resistance value of sampling resistor 218. The secondary current 214 may be used to derive and determine the primary current 212.

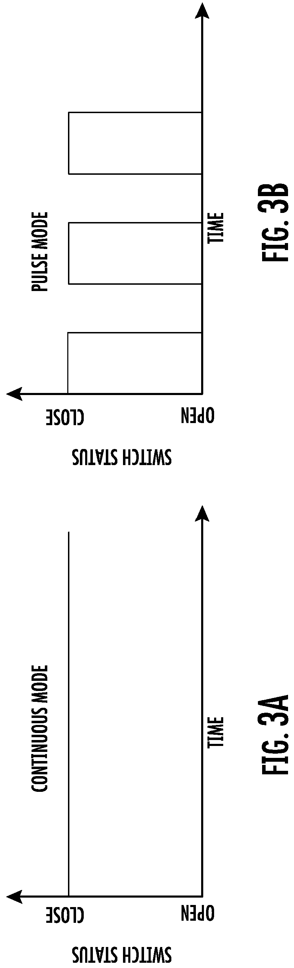

Current sensor 200 further comprises a switch 222 configured between the amplifier 210 and the secondary winding 208. The switch 222 may be configured to open or close a circuit path (e.g., between the amplifier 210 to the secondary winding 208) that allows a feedback current 216 to be transmitted from the amplifier 210 to the secondary winding 208, and thereby toggling operation of the current sensor 200 (e.g., on or off). According to the claimed subject-matter, switch 222 is configured to operate in either a continuous mode or a pulse mode based on a control signal received from a controller unit. In some embodiments, current sensor 200 is configured to operate in a continuous mode when greater measurement accuracy (e.g., of an alternating current (AC) associated with sampling voltage 220) is desired. In some other embodiments, current sensor 200 is configured to operate in a pulse mode when lower power consumption or a lower operating temperature is desired. Examples of continuous mode control signals and pulse mode control signals that may be transmitted to and received by switch 222 are depicted in FIG. 3A and FIG. 3B.

FIG. 3A depicts an example continuous mode control signal in accordance with various embodiments of the present disclosure. As depicted in FIG. 3A, a switch configured to toggle operation of a current sensor (e.g., switch 222) is controllable via control signals comprising "close" or "open" values that are associated with a close switch status or an open switch status, respectively. According to various embodiments of the present disclosure, a close switch status comprises a switch in a closed position thereby causing a current sensor (e.g., current sensor 200) to be "on" or enabled (e.g., a closed circuit). Conversely, an open switch status comprises a switch in an open position thereby causing a current sensor to be "off" or disabled (e.g., an open circuit). As depicted in FIG. 3A and FIG. 3B, a "close" value comprises a non-zero value and an "open" value comprises a zero value. However, in other embodiments, a "close" value may comprise a zero value and an "open" value may comprise a non-zero value. "Close" and "open" values may be arbitrarily designated and are not limited to the values disclosed herewith.

As further depicted in FIG. 3A, a continuous mode control signal comprises a steady "close" value over a given time period. A steady "close" value, as depicted in FIG. 3A, may be received by a switch during which a current sensor associated with the switch is directed to operate in a continuous mode. During a continuous mode, a steady "close" value may allow an output from amplifier 210 (e.g., feedback current 216) to be transmitted to secondary winding 208 in a continuous manner thereby allowing continuous operation of current sensor 200 and continuous readings to determine the secondary current 214.

FIG. 3B depicts an example pulse mode control signal in accordance with various embodiments of the present disclosure. As depicted in FIG. 3B, a pulse mode control signal comprises alternating "close" and "open" values over a given time period. Alternating "close" and "open" values, as depicted in FIG. 3B, may be received by a switch during which a current sensor associated with the switch is directed to operate in a pulse mode. During a pulse mode, a switch associated with a current sensor transitions between open and close positions and may allow output from amplifier 210 (e.g., feedback current 216) to be periodically transmitted to secondary winding 208 thereby allowing periodic operation of current sensor 200 and periodic readings to determine the secondary current 214.

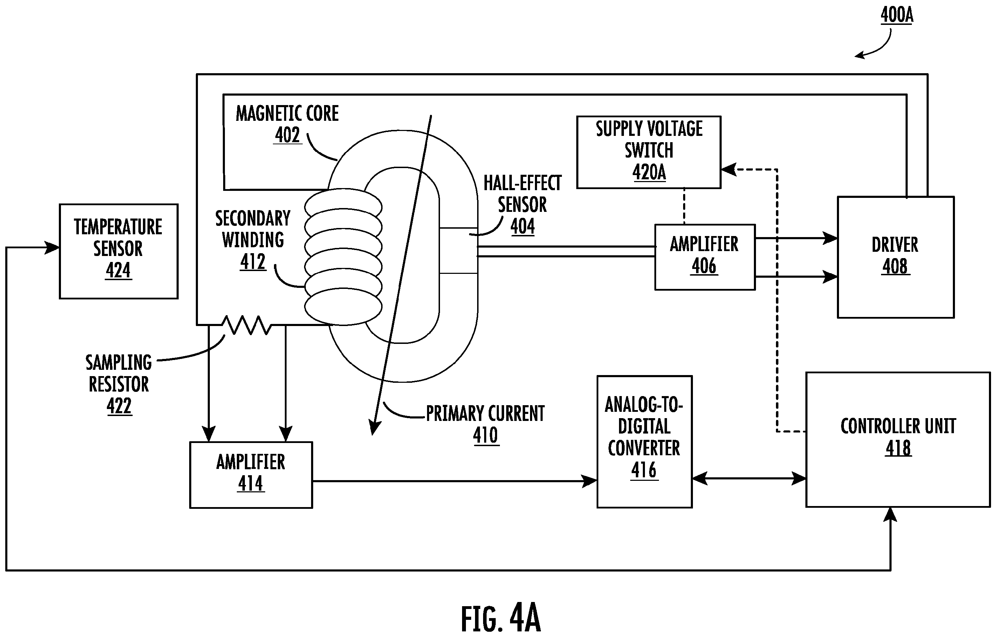

FIG. 4A is a block diagram of an example current sensor apparatus 400A in accordance with various embodiments of the present disclosure. The current sensor apparatus 400A comprises a magnetic core 402 and a Hall-effect sensor 404 configured within an air gap along a core body of the magnetic core 402. Inserting a conductor material carrying a primary current 410 into an inner void defined by magnetic core 402 may cause a magnetic flux that is detectable by Hall-effect sensor 404. The Hall-effect sensor 404 may generate a voltage output (e.g., Hall voltage) that is proportional to the strength of the magnetic flux which in turn is proportional to the amount of primary current 410. The voltage output from the Hall-effect sensor 404 may be amplified by amplifier 406 to generate an amplified voltage used by driver 408 to drive a feedback current through a secondary winding 412 from a first end of the secondary winding 412 to a second end of the secondary winding 412. The secondary winding 412 is coiled around a portion of the magnetic core such that when feedback current is driven through the secondary winding 412, zero-flux may be achieved.

A sampling resistor 422 is configured in series with a second end of the secondary winding 412. Voltage signals may be taken from across (e.g., in parallel) the sampling resistor 422 and amplified by amplifier 414. Amplified voltage from amplifier 414 may be converted by an analog-to-digital converter 416 into a digital voltage signal suitable for input to a controller unit 418. The controller unit 418 may comprise one or more complex programmable logic devices (CPLDs), microprocessors, multi-core processors, coprocessing entities, application-specific instruction-set processors (ASIPs), microcontrollers, and/or controllers.

Further, the controller unit 418 may be embodied as one or more other processing devices or circuitry. The term circuitry may refer to an entirely hardware embodiment or a combination of hardware and computer program products. Thus, the controller unit 418 may be embodied as integrated circuits, application specific integrated circuits (ASICs), field programmable gate arrays (FPGAs), programmable logic arrays (PLAs), hardware accelerators, other circuitry, and/or the like.

As will therefore be understood, the controller unit 418 may be configured for a particular use or configured to execute instructions stored in volatile or non-volatile media or otherwise accessible to the controller unit 418. As such, whether configured by hardware or computer program products, or by a combination thereof, the controller unit 418 may be capable of performing steps or operations according to embodiments of the present disclosure when configured accordingly.

According to various embodiments of the present disclosure, the digital voltage signal comprises a (sampling) voltage taken across the sampling resistor 422. Given a known value of sampling resistor 422, the controller unit 418 may receive the digital voltage signal from analog-to-digital converter 416 and determine a secondary current to determine a value of the primary current 410. Thus, controller unit 418 may be configured to determine the primary current 410 based on the voltage taken across the sampling resistor 422.

A supply voltage switch 420A is coupled between the amplifier 406 and the controller unit 418. In some embodiments, the controller unit 418 may configure an operation mode of current sensor apparatus 400A by transmitting control signals to supply voltage switch 420A. Supply voltage switch 420A is coupled to a supply voltage of amplifier 406 and may be controlled by the controller unit 418 (e.g., via continuous mode and pulse mode control signals) to switch the amplifier 406 on and off.

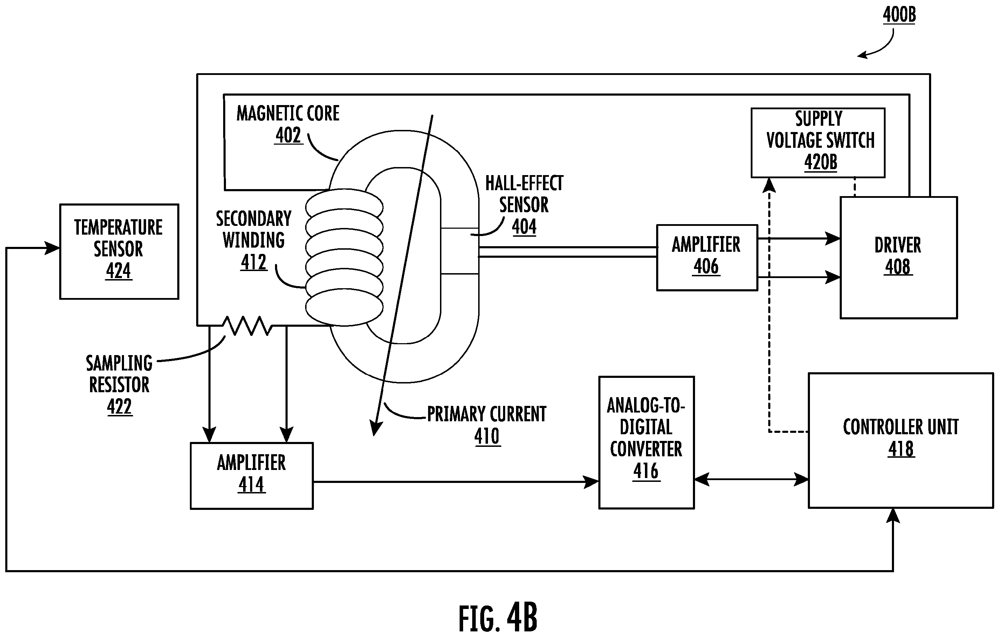

FIG. 4B is a block diagram of an alternative example current sensor apparatus 400B in accordance with various embodiments of the present disclosure. As depicted in FIG. 4B, a supply voltage switch 420B is coupled between driver 408 and controller unit 418 for configuring an operation mode of current sensor apparatus 400B. In some embodiments, the controller unit 418 may configure an operation mode of current sensor apparatus 400B by transmitting control signals to supply voltage switch 420B. Supply voltage switch 420B is coupled to a supply voltage of driver 408 and may be controlled by the controller unit 418 (e.g., via continuous mode and pulse mode control signals) to switch the driver 408 on and off.

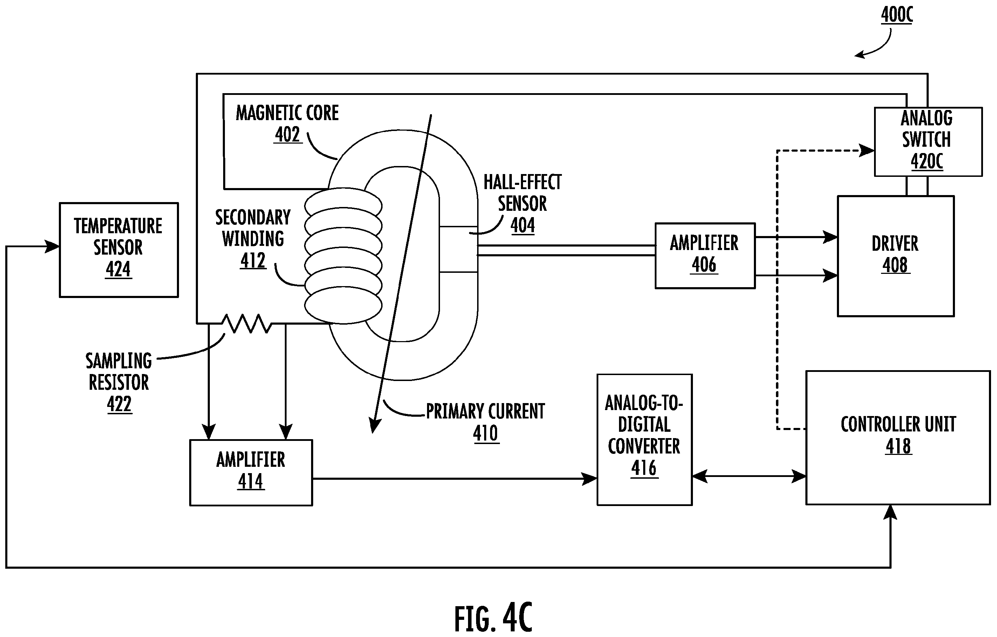

FIG. 4C is a block diagram of another alternative current sensor apparatus 400C in accordance with various embodiments of the present disclosure. As depicted in FIG. 4C, an analog switch 420C is configured between driver 408 and secondary winding 412 for configuring an operation mode of current sensor apparatus 400C. In some embodiments, the controller unit 418 may configure an operation mode of current sensor apparatus 400C by transmitting control signals to analog switch 420C.

Analog switch 420C may be controlled by the controller unit 418 (e.g., via continuous mode and pulse mode control signals) to open and close a pathway between driver 408 and secondary winding 412 that is used to drive a feedback current drive to secondary winding 412.

In some embodiments, the controller unit 418 may determine an operation mode to configure any of current sensor apparatus 400A, 400B, and 400C based on component temperature, such as of sampling resistor 422. As further depicted in FIG. 4A, FIG. 4B, and FIG. 4C, current sensor apparatus 400A, 400B, and 400C further comprise a temperature sensor 424. The temperature sensor 424 may be configured to monitor temperature of sampling resistor 422. The temperature sensor 424 may generate data signals representative of a temperature of sampling resistor 422. The signals generated by temperature sensor 424 may be transmitted to and received by the controller unit 418 to determine whether the temperature of the sampling resistor 422 exceeds a temperature threshold. In some example embodiments, the controller unit 418 may configure the current sensor apparatus 400A, 400B, and 400C to operate in a pulse mode based on a determination that the sampling resistor 422 is operating at a temperature that exceeds a temperature threshold.

According to the claimed subject-matter, one or more of current sensor apparatuses 400A, 400B, or 400C operate in either continuous mode or pulse mode based on one or more operational thresholds. In some embodiments, if a primary current determined by one or more of current sensor apparatuses 400A, 400B, or 400C (based on a determination of and derivation from secondary current) is higher than a defined threshold, one or more of the current sensor apparatuses 400A, 400B, or 400C are configured by a processing device, such as controller unit 418, to operate in a pulse mode to lower power consumption. In some other embodiments, if an operating temperature (e.g., determined using temperature sensor 424) is higher than a temperature threshold, the one or more of current sensor apparatuses 400A, 400B, or 400C are configured by a processing device to operate in a pulse mode to lower heating. In the claimed subject-matter, if a frequency of a primary current comprising an AC current is determined by one or more of current sensor apparatuses 400A, 400B, or 400C to be higher than a threshold, the one or more of current sensor apparatuses 400A, 400B, or 400C are configured by a processing device to operate in a continuous mode thereby providing a sufficient sampling rate to ensure accurate determination of the primary current.

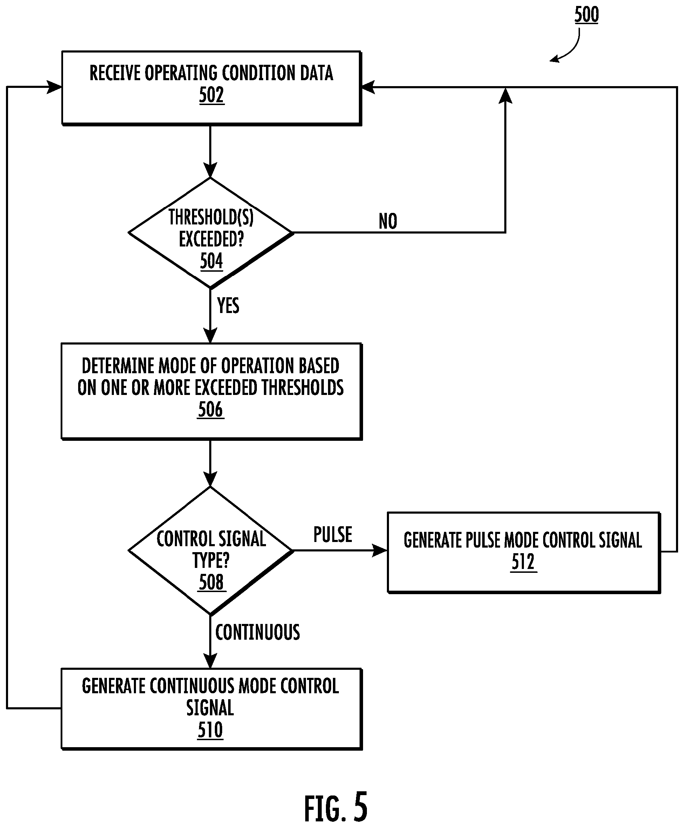

Referring now to FIG. 5, an example flow diagram illustrating an exemplary method for controlling a current sensor in accordance with some example embodiments of the present disclosure. It is noted that each block of a flowchart, and combinations of blocks in the flowchart, may be implemented by various means such as hardware, firmware, circuitry, and/or other devices associated with execution of software including one or more computer program instructions. For example, one or more of the steps/operations described in FIG. 5 may be embodied by computer program instructions, which may be stored by a non-transitory memory of an apparatus employing an embodiment of the present disclosure and executed by a processor component in an apparatus (such as, but not limited to, controller unit 418). For example, these computer program instructions may direct the processor component to function in a particular manner, such that the instructions stored in the computer-readable storage memory produce an article of manufacture, the execution of which implements the function specified in the flowchart block(s).

In FIG. 5, the example method 500 may be executed by a computing device associated with a current sensor (for example, as illustrated and described herewith). At step 502, operating condition data associated with a current sensor is received. In some embodiments, operating condition data comprises temperature data, a current measurement value, or a current frequency value. Temperature data may be associated with a temperature of one or more components within the current sensor, such as a sampling resistor from which a voltage reading is taken (e.g., to determine a secondary current and derive/determine a primary current based on the secondary current). The current measurement value may be associated with a determined secondary current or a derived/determined primary current. The current frequency value may be associated with a frequency (e.g., rate at which current changes direction per second) of a primary current comprising an AC current to be derived/determine.

In the claimed subject-matter, subsequent to step 502, the example method proceeds to step 504, where the operating condition data is analyzed to determine or detect whether one or more thresholds have been exceeded. In the claimed subject-matter, the one or more thresholds include a primary current threshold TH_IP, a temperature threshold TH_temp, or a primary current frequency threshold TH_freq.

In some embodiments, subsequent to step 504, if no thresholds have been exceeded, operation condition data may continue to be received and monitored for exceeding one or more thresholds via steps 502 and 504.

In some embodiments, subsequent to step 504, if one or more thresholds have been exceeded, the example method proceeds to step 506, where a mode of operation is determined based on the one or more exceeded thresholds. For example, if a primary current determined by the current sensor is higher than a primary current threshold (e.g., 600A), the current sensor may be configured to enter a pulse mode to lower power consumption. In another example, if a current sensor's temperature (or its components) is higher than a temperature threshold (e.g., 158F or 70°C), then the current sensor may be configured to enter a pulse mode to lower heating. In yet another example, if a primary current frequency (e.g., frequency of the primary current comprising an AC current) is higher than a frequency threshold (e.g., 400Hz), then the current sensor may be configured to enter a continuous mode to be able to capture the primary current operating at the primary current frequency to provide sensing accuracy.

In some embodiments, determining the mode of operation further comprises determining an optimization target. An optimization target may be determined for instances where more than one threshold are exceeded. In some embodiments, the one or more exceeded thresholds may be prioritized in dictating which mode of operation the current sensor should operate in. For example, a current sensor may be configured in pulse mode for lowering power consumption and current sensor temperature, however, measurement accuracy may be prioritized over power consumption and/or current sensor temperature. That is, a current sensor according to the claimed subject-matter is configured in continuous mode based on the primary current frequency exceeding a frequency threshold despite exceeding power consumption and/or current sensor temperature thresholds.

In some other embodiments, the one or more thresholds further comprise one or more safety thresholds. A safety threshold may comprise a threshold that takes precedence over non-safety threshold. For example, the primary current threshold TH_IP, the temperature threshold TH_temp, or the primary current frequency threshold TH_freq may comprise non-safety thresholds. In some example embodiments, a safety threshold comprises a safety temperature threshold or an overcurrent threshold that takes precedence over the primary current frequency threshold TH_freq. As such, in the event of exceeding a safety temperature threshold or an overcurrent threshold, a current sensor may be configured in a pulse mode or a mode where a switch status of the current sensor is configured in an open position.

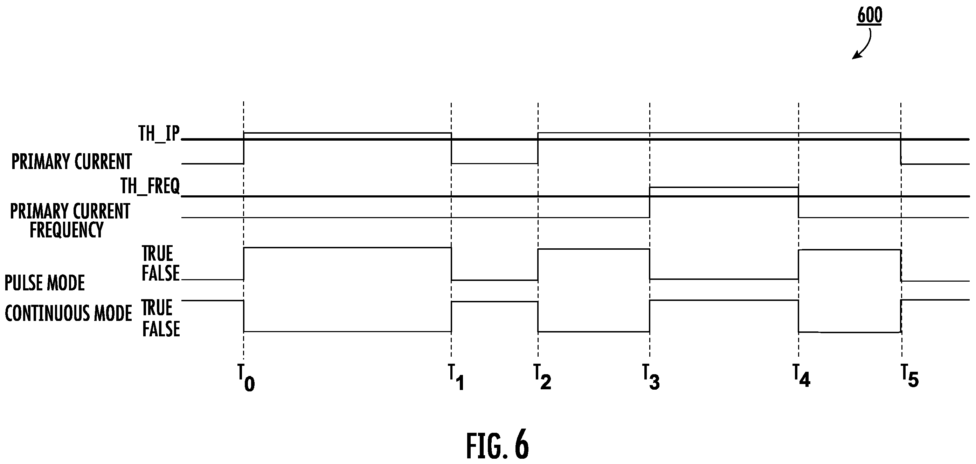

FIG. 6 depicts an example timing diagram for optimizing power consumption in accordance with some example embodiments of the present disclosure. Optimizing power consumption may comprise monitoring a determined primary current and a primary current frequency. Optimizing power consumption may further comprise configuring a current sensor to operate in either a pulse mode or a continuous mode based on the determined primary current and/or the primary current frequency exceeding or not exceeding a primary current threshold TH_IP and/or a primary current frequency threshold TH_freq, respectively.

As depicted in FIG. 6, a current sensor is configured in continuous mode based on (i) the determined primary current not exceeding the primary current threshold TH_IP and (ii) the primary current frequency not exceeding the primary current frequency threshold TH_freq (e.g., before $T_0$, $T_1$-$T_2$, and after $T_5$). In the event that only the determined primary current exceeds primary current threshold TH_IP, the current sensor may be configured to operate in pulse mode (e.g., $T_0$-$T_1$, $T_2$-$T_3$, and $T_4$-$T_5$) to lower power consumption. When the primary current frequency exceeds the primary current frequency threshold TH_freq, the current sensor according to the claimed subject-matter is configured to operate in continuous mode (e.g., regardless of the determined primary current exceeding or not exceeding the primary current threshold TH_IP) such that the current sensor is able to capture the primary current operating at the primary current frequency (e.g., $T_3$-$T_4$).

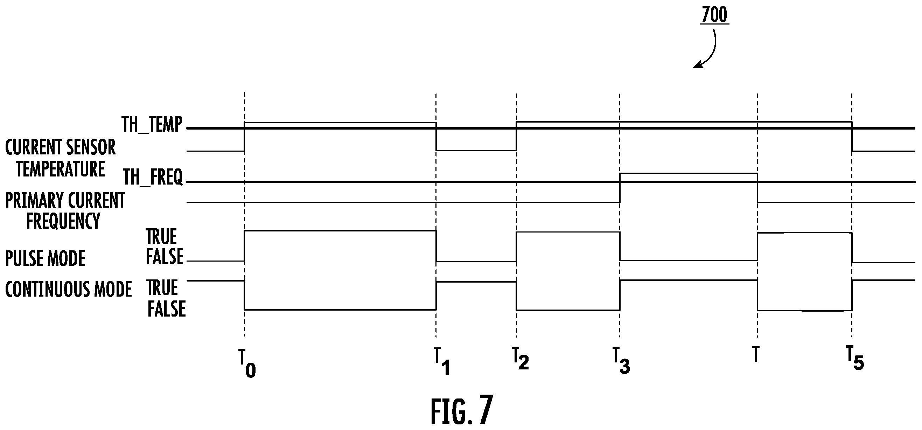

FIG. 7 depicts an example timing diagram for optimizing current sensor temperature in accordance with some example embodiments of the present disclosure. Optimizing current sensor temperature may comprise monitoring a current sensor temperature and a primary current frequency. Optimizing current sensor temperature may further comprise configuring a current sensor to operate in either a pulse mode or a continuous mode based on the current sensor temperature and/or the primary current frequency exceeding or not exceeding a temperature threshold TH_temp and/or a primary current frequency threshold TH_freq, respectively.

As depicted in FIG. 7, a current sensor may be configured in continuous mode based on (i) the current sensor temperature not exceeding the temperature threshold TH_temp and (ii) the primary current frequency not exceeding the primary current frequency threshold TH_freq (e.g., before $T_0$, $T_1$-$T_2$, and after $T_5$). In the event that only the current sensor temperature is higher than temperature threshold TH_temp, the current sensor may be configured to operate in pulse mode (e.g., $T_0$-$T_1$, $T_2$-$T_3$, and $T_4$-$T_5$) to lower heating. When the primary current frequency exceeds the primary current frequency threshold TH_freq, the current sensor according to the claimed subject-matter is configured to operate in continuous mode (e.g., regardless of the current sensor temperature exceeding or not exceeding the temperature threshold TH_temp) such that the current sensor is able to capture the primary current operating at the primary current frequency (e.g., $T_3$-$T_4$).

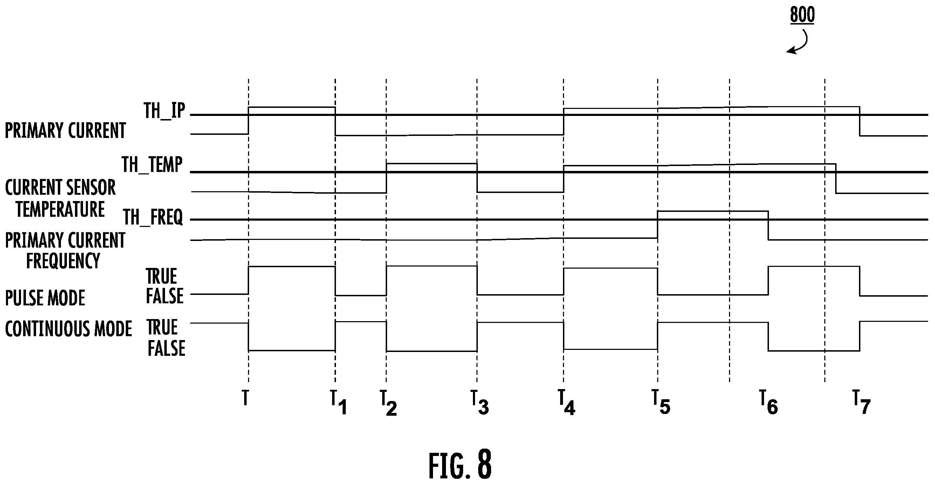

FIG. 8 depicts an example timing diagram for optimizing both power consumption and current sensor temperature in accordance with some example embodiments of the present disclosure. Optimizing power consumption and current sensor temperature simultaneously may comprise monitoring a determined primary current, a current sensor temperature, and a primary current frequency. Optimizing for both power consumption and current sensor temperature may further comprise configuring a current sensor to operate in either a pulse mode or a continuous mode based one or more of the determined primary current, the current sensor temperature, and/or the primary current frequency exceeding or not exceeding a primary current threshold TH_IP, a temperature threshold TH_temp, and/or a primary current frequency threshold TH_freq, respectively.

As depicted in FIG. 8, a current sensor is configured in continuous mode based on (i) the determined primary current not exceeding the primary current threshold TH _IP, (ii) the current sensor temperature not exceeding the temperature threshold TH_temp, and (iii) the primary current frequency not exceeding the primary current frequency threshold TH_freq (e.g., before T0, T1-T2, T3-T4, and after T7). The current sensor is configured in pulse mode based on one or more of (i) the determined primary current exceeding the primary current threshold TH_IP or (ii) the current sensor temperature exceeding the temperature threshold TH_temp. When the primary current frequency exceeds the primary current frequency threshold TH_freq, the current sensor according to the claimed subject-matter is configured to operate in continuous mode (e.g., regardless of the determined primary current exceeding or not exceeding the primary current threshold TH_IP or the current sensor temperature exceeding or not exceeding the temperature threshold TH_temp) such that the current sensor is able to capture the primary current operating at the primary current frequency (e.g., $T_5$-$T_6$).

Returning to FIG. 5, in some embodiments, subsequent to step 506, the example method proceeds to step 508, where a control signal type is determined based on the determined mode of operation. According to various embodiments of the present disclosure, the control signal type may be determined to be either a continuous mode control signal or a pulse mode control signal. For example, a continuous mode control signal may be determined for a continuous mode and a pulse mode control signal may be determined for a pulse mode.

In some embodiments, subsequent to step 508, if the determined control signal type is a continuous mode control signal, the example method proceeds to step 510, where a continuous mode control signal is generated. In some embodiments, a continuous mode control signal comprises a steady "close" value over a given time period. The generated continuous mode control signal may be received by a switch and used to control operation of the current sensor to continuously operate and persistently obtain readings for determining primary current. In some embodiments, subsequent to step 510, the example method proceeds to step 502.

In some embodiments, subsequent to step 508, if the determined control signal type is a pulse mode control signal, the example method proceeds to step 512, where a pulse mode control signal is generated. In some embodiments, a pulse mode control signal comprises alternating "close" and "open" values over a given time period. The generated pulse mode control signal may be received by a switch and used to control operation of the current sensor to operate at periodic intervals of time and obtain readings to determine primary current during the periodic intervals of time. In some embodiments, phase and/or duty cycle associated with a pulse mode control signal may be adjusted to achieve a desired optimization target (e.g., lower power consumption, lower heating, or both) and desired sensing accuracy as well. In some embodiments, subsequent to step 512, the example method proceeds to step 502.

It is to be understood that the disclosure is not to be limited to the specific embodiments disclosed, and that modifications and other embodiments are intended to be included within the scope of the appended claims. Although specific terms are employed herein, they are used in a generic and descriptive sense only and not for purposes of limitation, unless described otherwise.

**Claims**

1. A system comprising:

   a controller unit and
   a current sensor (200) comprising:

      a magnetic core (204) comprising (i) a core body and (ii) an air gap along the core body;
      a magnetic transducer (206) configured in the air gap;
      an amplifier (210) coupled to the magnetic transducer (206);
      a secondary winding (208) comprising a wire coil that is extended around the core body;
      a switch (222) coupled between the amplifier (210) and the secondary winding (208), the switch (222) configured to open or close a circuit path between the amplifier (210) and the secondary winding (208) by operating in a continuous mode or a pulse mode based on a control signal;
      wherein the controller unit is configured to generate the control signal, **characterized in that** :

         the control signal is generated based on operating condition data, wherein the operating condition data is analyzed to determine whether one or more thresholds have been exceeded;
         wherein the one or more thresholds include at least one of a primary current threshold, a temperature threshold, or a primary current frequency threshold, and
         wherein the continuous mode is determined based on prioritization of the primary current frequency threshold over one or more of the primary current threshold or the temperature threshold.

2. The system of claim 1, wherein the switch (222) is configured to allow a feedback current from the amplifier (210) to the secondary winding (208) via the circuit path.

3. The system of claim 1, wherein the continuous mode comprises operating the switch (222) based on the control signal comprising a continuous mode control signal that comprises a steady close value.

4. The system of claim 1, wherein the pulse mode comprises operating the switch (222) based on the control signal comprising a pulse mode control signal that comprises a plurality of alternating open values and close values.

5. An apparatus (400A; 400B; 400C) comprising:

a magnetic core (402) comprising (i) a core body and (ii) an air gap along the core body;
a Hall-effect sensor (404) configured in the air gap;
an amplifier (406) coupled to the Hall-effect sensor (404);
a driver (408) coupled to the amplifier (406);
a secondary winding (412) comprising (i) a wire coil that is extended around the core body and (ii) a first end coupled to the driver (408), and (iii) a second end coupled to a sampling resistor (422);
a switch (420A; 420B; 420C) configured to allow a feedback current from the driver (408) to the secondary winding (412);
a controller unit (418) coupled to the switch (420A; 420B; 420C), the controller unit (418) configured to (i) receive a digital signal based on a sampling voltage associated with the sampling resistor (422), (ii) generate one or more control signals based on operating condition data that comprises at least the digital signal exceeding one or more thresholds, and (iii) transmit the one or more control signals to the switch (420A; 420B; 420C);
wherein the one or more thresholds include at least one of a primary current threshold, a temperature threshold, or a primary current frequency threshold, **characterized in that**:
the controller unit (418) is further configured to generate a continuous mode control signal based on prioritization of the primary current frequency threshold over one or more of the primary current threshold or the temperature threshold.

6. The apparatus (400A; 400B; 400C) of claim 5 further comprising a temperature sensor (424) coupled to the controller unit (418), the temperature sensor (424) configured to:

generate data signals representative of a temperature of the sampling resistor (422); and
transmit the data signals to the controller unit (418).

7. The apparatus (400A; 400B; 400C) of claim 5 wherein the switch (420A, 420B, 420C) is configured between the controller unit (418) and the amplifier (406).

8. The apparatus (400A; 400B; 400C) of claim 5 wherein the switch (420A, 420B, 420C) is configured between the controller unit (418) and the driver (408).

9. The apparatus (400A; 400B; 400C) of claim 5 wherein the switch (420A, 420B, 420C) is configured between the driver (408) and the secondary winding (412).

10. A method (500) for controlling a current sensor (200), the method comprising:

receiving (502), by one or more processors, operating condition data associated with the current sensor (200);
determining (504), by the one or more processors, one or more thresholds have been exceeded based on the operating condition data, wherein the one or more thresholds include a primary current threshold, a temperature threshold, or a primary current frequency threshold;
determining (506), by the one or more processors, a mode of operation based on the one or more thresholds;
determining (508), by the one or more processors, a control signal type based on the mode of operation; and
generating (510; 512) a control signal based on the control signal type, wherein (i) the control signal comprises one of a continuous mode control signal or a pulse mode control signal and (ii) is received by a switch associated with the current sensor (200) and used to configure the current sensor (200) to operate in the mode of operation;
**characterized in that**:
the continuous mode control signal is determined based on prioritization of the primary current frequency threshold over one or more of the primary current threshold or the temperature threshold.

11. The method (500) of claim 10, wherein the operating condition data comprises temperature data, a current measurement value, or a current frequency value.

12. The method (500) of claim 10 further comprising determining (506) a pulse mode as the mode of operation based on a detection of a primary current that is higher than the primary current threshold or a temperature that is higher than the temperature threshold.

**13.** The method (500) of claim 10, wherein the one or more thresholds comprise a safety threshold that comprises precedence over the primary current threshold, the temperature threshold, or the primary current frequency threshold.

**Patentansprüche**

**1.** System, umfassend:

eine Steuereinheit und
einen Stromsensor (200), umfassend:

einen Magnetkern (204), umfassend (i) einen Kernkörper und (ii) einen Luftspalt entlang dem Kernkörper;
einen Magnetwandler (206), der in dem Luftspalt konfiguriert ist;
einen mit dem Magnetwandler (206) gekoppelten Verstärker (210);
eine Sekundärwicklung (208), umfassend eine Drahtspule, die sich um den Kernkörper herum erstreckt;
einen Schalter (222), der zwischen dem Verstärker (210) und der Sekundärwicklung (208) gekoppelt ist, wobei der Schalter (222) dazu konfiguriert ist, einen Schaltungspfad zwischen dem Verstärker (210) und der Sekundärwicklung (208) zu öffnen oder zu schließen, indem er auf Basis eines Steuersignals in einem kontinuierlichen Modus oder in einem Pulsmodus betrieben wird;
wobei die Steuereinheit dazu konfiguriert ist, das Steuersignal zu erzeugen, **gekennzeichnet dadurch, dass**:

das Steuersignal auf Basis von Betriebszustandsdaten erzeugt wird, wobei die Betriebszustandsdaten analysiert werden, um zu bestimmen, ob ein oder mehrere Schwellenwerte überschritten wurden;
wobei der eine oder die mehreren Schwellenwerte mindestens einen von einem Primärstromschwellenwert, einem Temperaturschwellenwert oder einem Primärstromfrequenzschwellenwert beinhalten, und
wobei der kontinuierliche Modus auf Basis einer Priorisierung des Primärstromfrequenzschwellenwertes über einem oder mehrere von dem Primärstromschwellenwert oder dem Temperaturschwellenwert bestimmt wird.

**2.** System nach Anspruch 1, wobei der Schalter (222) dazu konfiguriert ist, einen Rückspeisestrom von dem Verstärker (210) zu der Sekundärwicklung (208) über den Schaltungspfad zu erlauben.

**3.** System nach Anspruch 1, wobei der kontinuierliche Modus das Betreiben des Schalters (222) auf Basis des Steuersignals umfasst, umfassend ein Kontinuierlicher-Modus-Steuersignal, das einen Ständig-Geschlossen-Wert umfasst.

**4.** System nach Anspruch 1, wobei der Pulsmodus das Betreiben des Schalters (222) auf Basis des Steuersignals umfasst, umfassend ein Pulsmodus-Steuersignal, das eine Vielzahl von abwechselnden Offen-Werten und Geschlossen-Werten umfasst.

**5.** Einrichtung (400A; 400B; 400C), umfassend:

einen Magnetkern (402), umfassend (i) einen Kernkörper und (ii) einen Luftspalt entlang dem Kernkörper;
einen Hall-Effekt-Sensor (404), der in dem Luftspalt konfiguriert ist;
einen mit dem Hall-Effekt-Sensor (404) gekoppelten Verstärker (406);
einen mit dem Verstärker (406) gekoppelten Treiber (408);
eine Sekundärwicklung (412), umfassend (i) eine Drahtspule, die sich um den Kernkörper erstreckt, und (ii) ein mit dem Treiber (408) gekoppeltes erstes Ende, und (iii) ein mit einem Abtastwiderstand (422) gekoppeltes zweites Ende;
einen Schalter (420A; 420B; 420C), der dazu konfiguriert ist, einen Rückspeisestrom von dem Treiber (408) zu der Sekundärwicklung (412) zu erlauben;
eine mit dem Schalter (420A; 420B; 420C) gekoppelte Steuereinheit (418), wobei die Steuereinheit (418) dazu konfiguriert ist, (i) ein digitales Signal auf Basis einer Abtastspannung, die dem Abtastwiderstand (422) zugehörig ist, zu erzeugen, (ii) ein oder mehrere Steuersignale auf Basis darauf zu erzeugen, dass Betriebszustandsdaten, die mindestens das digitale Signal umfassen, einen oder mehrere Schwellenwerte überschreiten, und (iii) das eine oder die mehreren Steuersignale an den Schalter (420A; 420B; 420C) zu übertragen;
wobei der eine oder die mehreren Schwellenwerte mindestens einen von einem Primärstromschwellenwert, einem Temperaturschwellenwert oder einem Primärstromfrequenzschwellenwert beinhalten, **gekennzeichnet dadurch, dass**:
die Steuereinheit (418) ferner dazu konfiguriert ist, ein Kontinuierlicher-Modus-Steuersignal auf Basis einer Priorisierung des Primärstromfrequenzschwellenwertes über einem oder mehrere von dem Primärstromschwellenwert oder dem Temperaturschwellenwert zu erzeugen.

6. Einrichtung (400A; 400B; 400C) nach Anspruch 5, ferner umfassend einen Temperatursensor (424), der mit der Steuereinheit (418) gekoppelt ist, wobei der Temperatursensor (424) dazu konfiguriert ist:

    Datensignale zu erzeugen, die repräsentativ für eine Temperatur des Abtastwiderstands (422) sind; und
    die Datensignale an die Steuereinheit (418) zu übertragen.

7. Einrichtung (400A; 400B; 400C) nach Anspruch 5, wobei der Schalter (420A, 420B, 420C) zwischen der Steuereinheit (418) und dem Verstärker (406) konfiguriert ist.

8. Einrichtung (400A; 400B; 400C) nach Anspruch 5, wobei der Schalter (420A, 420B, 420C) zwischen der Steuereinheit (418) und dem Treiber (408) konfiguriert ist.

9. Einrichtung (400A; 400B; 400C) nach Anspruch 5, wobei der Schalter (420A, 420B, 420C) zwischen dem Treiber (408) und der Sekundärwicklung (412) konfiguriert ist.

10. Verfahren (500) zum Steuern eines Stromsensors (200), das Verfahren umfassend:

    Empfangen (502), durch einen oder mehrere Prozessoren, von Betriebszustandsdaten, die dem Stromsensor (200) zugehörig sind;
    Bestimmen (504), durch den einen oder die mehreren Prozessoren, dass einer oder mehrere Schwellenwerte überschritten wurden, auf Basis der Betriebszustandsdaten, wobei der eine oder die mehreren Schwellenwerte einen von einem Primärstromschwellenwert, einem Temperaturschwellenwert oder einem Primärstromfrequenzschwellenwert beinhalten;
    Bestimmen (506), durch den einen oder die mehreren Prozessoren, eines Betriebsmodus auf Basis des einen oder der mehreren Schwellenwerte;
    Bestimmen (508), durch den einen oder die mehreren Prozessoren, eines Steuersignaltyps auf Basis des Betriebsmodus; und
    Erzeugen (510; 512) eines Steuersignals auf Basis des Steuersignaltyps, wobei (i) das Steuersignal eines von einem Kontinuierlicher-Modus-Steuersignal oder einem Pulsmodus-Steuersignal umfasst und (ii) von einem dem Stromsensor (200) zugehörigen Schalter empfangen wird und dazu verwendet wird, den Stromsensor (200) dazu zu konfigurieren, in dem Betriebsmodus betrieben zu werden;
**dadurch gekennzeichnet, dass**
das Kontinuierlicher-Modus-Steuersignal auf Basis einer Priorisierung des Primärstromfrequenzschwellenwertes über einem oder mehrere von dem Primärstromschwellenwert oder dem Temperaturschwellenwert bestimmt wird.

11. Verfahren (500) nach Anspruch 10, wobei die Betriebszustandsdaten Temperaturdaten, einen Strommesswert oder einen Stromfrequenzwert umfassen.

12. Verfahren (500) nach Anspruch 10, ferner umfassend Bestimmen (506) eines Pulsmodus als den Betriebsmodus auf Basis einer Erkennung eines Primärstroms, der höher ist als der Primärstromschwellenwert, oder einer Temperatur, die höher ist als der Temperaturschwellenwert.

13. Verfahren (500) nach Anspruch 10, wobei der eine oder die mehreren Schwellenwerte einen Sicherheitsschwellenwert umfassen, der einen Vorrang über den Primärstromschwellenwert, den Temperaturschwellenwert oder den Primärstromfrequenzschwellenwert umfasst.

## Revendications

1. Système comprenant :

    une unité de commande et
    un capteur de courant (200) comprenant :

        un noyau magnétique (204) comprenant (i) un corps de noyau et (ii) un entrefer le long du corps de noyau ;
        un transducteur magnétique (206) configuré dans l'entrefer ;
        un amplificateur (210) couplé au transducteur magnétique (206) ;
        un enroulement secondaire (208) comprenant une bobine de fil qui est étendue autour du corps de noyau ;
        un interrupteur (222) couplé entre l'amplificateur (210) et l'enroulement secondaire (208), l'interrupteur (222) étant configuré pour ouvrir ou fermer un chemin de circuit entre l'amplificateur (210) et l'enroulement secondaire (208) en fonctionnant dans un mode continu ou un mode impulsionnel sur la base d'un signal de commande ;
        dans lequel l'unité de commande est configurée pour générer le signal de commande, **caractérisé en ce que** :

le signal de commande est généré sur la base de données de condition de fonctionnement, dans lequel les données de condition de fonctionnement sont analysées pour déterminer si un ou plusieurs seuils ont été dépassés ; dans lequel lesdits un ou plusieurs seuils incluent au moins l'un parmi un seuil de courant primaire, un seuil de température, ou un seuil de fréquence de courant primaire, et dans lequel le mode continu est déterminé sur la base d'une priorisation du seuil de fréquence de courant primaire par rapport à un ou plusieurs parmi le seuil de courant primaire ou le seuil de température.

2. Système de la revendication 1, dans lequel l'interrupteur (222) est configuré pour permettre un courant de rétroaction depuis l'amplificateur (210) vers l'enroulement secondaire (208) via le chemin de circuit.

3. Système de la revendication 1, dans lequel le mode continu comprend le fonctionnement de l'interrupteur (222) sur la base du signal de commande comprenant un signal de commande de mode continu qui comprend une valeur de fermeture stable.

4. Système de la revendication 1, dans lequel le mode impulsionnel comprend le fonctionnement de l'interrupteur (222) sur la base du signal de commande comprenant un signal de commande de mode impulsionnel qui comprend une pluralité de valeurs d'ouverture et de valeurs de fermeture alternées.

5. Appareil (400A ; 400B ; 400C) comprenant :

   un noyau magnétique (402) comprenant (i) un corps de noyau et (ii) un entrefer le long du corps de noyau ; un capteur à effet Hall (404) configuré dans l'entrefer ; un amplificateur (406) couplé au capteur à effet Hall (404) ; un pilote (408) couplé à l'amplificateur (406) ; un enroulement secondaire (412) comprenant (i) une bobine de fil qui est étendue autour du corps de noyau et (ii) une première extrémité couplée au pilote (408), et (iii) une deuxième extrémité couplée à une résistance d'échantillonnage (422) ; un interrupteur (420A ; 420B ; 420C) configuré pour permettre un courant de rétroaction depuis le pilote (408) vers l'enroulement secondaire (412) ; une unité de commande (418) couplée à l'interrupteur (420A ; 420B ; 420C), l'unité de commande (418) étant configurée pour (i) recevoir un signal numérique sur la base d'une tension d'échantillonnage associée à la résistance d'échantillonnage (422), (ii) générer un ou plusieurs signaux de commande sur la base de données de condition de fonctionnement qui comprennent au moins le fait que le signal numérique dépasse un ou plusieurs seuils, et (iii) transmettre lesdits un ou plusieurs signaux de commande à l'interrupteur (420A ; 420B ; 420C) ; dans lequel lesdits un ou plusieurs seuils incluent au moins l'un parmi un seuil de courant primaire, un seuil de température, ou un seuil de fréquence de courant primaire, **caractérisé en ce que** : l'unité de commande (418) est en outre configurée pour générer un signal de commande de mode continu sur la base d'une priorisation du seuil de fréquence de courant primaire par rapport à un ou plusieurs parmi le seuil de courant primaire ou le seuil de température.

6. Appareil (400A ; 400B ; 400C) de la revendication 5 comprenant en outre un capteur de température (424) couplé à l'unité de commande (418), le capteur de température (424) étant configuré pour :

   générer des signaux de données représentatifs d'une température de la résistance d'échantillonnage (422) ; et transmettre les signaux de données à l'unité de commande (418).

7. Appareil (400A ; 400B ; 400C) de la revendication 5 dans lequel l'interrupteur (420A, 420B, 420C) est configuré entre l'unité de commande (418) et l'amplificateur (406).

8. Appareil (400A ; 400B ; 400C) de la revendication 5 dans lequel l'interrupteur (420A, 420B, 420C) est configuré entre l'unité de commande (418) et le pilote (408).

9. Appareil (400A ; 400B ; 400C) de la revendication 5 dans lequel l'interrupteur (420A, 420B, 420C) est configuré entre le pilote (408) et l'enroulement secondaire (412).

10. Procédé (500) de commande d'un capteur de courant (200), le procédé comprenant :

    la réception (502), par un ou plusieurs processeurs, des données de condition de fonctionnement associées au capteur de courant (200) ; la détermination (504), par lesdits un ou plusieurs processeurs, qu'un ou plusieurs seuils ont été dépassés sur la base des données de condition de fonctionnement, dans lequel lesdits un ou plusieurs seuils incluent un seuil de courant primaire, un seuil de température, ou un seuil de fréquence de courant primaire ;

la détermination (506), par lesdits un ou plusieurs processeurs, d'un mode de fonctionnement sur la base desdits un ou plusieurs seuils ;

la détermination (508), par lesdits un ou plusieurs processeurs, d'un type de signal de commande basé sur le mode de fonctionnement ; et

la génération (510 ; 512) d'un signal de commande sur la base du type de signal de commande, dans lequel (i) le signal de commande comprend l'un parmi un signal de commande de mode continu ou un signal de commande de mode impulsionnel et (ii) est reçu par un interrupteur associé au capteur de courant (200) et utilisé pour configurer le capteur de courant (200) afin de fonctionner dans le mode de fonctionnement ;

**caractérisé en ce que** :

le signal de commande de mode continu est déterminé sur la base d'une priorisation du seuil de fréquence de courant primaire par rapport à un ou plusieurs parmi le seuil de courant primaire ou le seuil de température.

11. Procédé (500) de la revendication 10, dans lequel les données de condition de fonctionnement comprennent des données de température, une valeur de mesure de courant, ou une valeur de fréquence de courant.

12. Procédé (500) de la revendication 10 comprenant en outre la détermination (506) d'un mode impulsionnel en tant que mode de fonctionnement sur la base d'une détection d'un courant primaire qui est supérieur au seuil de courant primaire ou d'une température qui est supérieure au seuil de température.

13. Procédé (500) de la revendication 10, dans lequel lesdits un ou plusieurs seuils comprennent un seuil de sécurité qui présente une priorité par rapport au seuil de courant primaire, au seuil de température, ou au seuil de fréquence de courant primaire.

SECONDARY
WINDING
108

MAGNETIC TRANSDUCER
106

FEEDBACK CURRENT
116

AMPLIFIER 100

PRIMARY CURRENT
112

SECONDARY
CURRENT
114

SAMPLING
VOLTAGE
120

$R_L$

SAMPLING RESISTOR
118

CONDUCTOR
102

MAGNETIC CORE
104

100

FIG. 1

EP 4 585 931 B1

FIG. 2

EP 4 585 931 B1

PULSE MODE

SWITCH STATUS

CLOSE

OPEN

TIME

FIG. 3B

CONTINUOUS MODE

SWITCH STATUS

CLOSE

OPEN

TIME

FIG. 3A

FIG. 4A

EP 4 585 931 B1

400B

SUPPLY VOLTAGE SWITCH
420B

DRIVER
408

CONTROLLER UNIT
418

AMPLIFIER
406

ANALOG-TO-DIGITAL CONVERTER
416

HALL-EFFECT SENSOR
404

MAGNETIC CORE
402

SECONDARY WINDING
412

PRIMARY CURRENT
410

SAMPLING RESISTOR
422

TEMPERATURE SENSOR
424

AMPLIFIER
414

**FIG. 4B**

FIG. 4C

EP 4 585 931 B1

FIG. 5

FIG. 6

EP 4 585 931 B1

FIG. 7

EP 4 585 931 B1

FIG. 8

EP 4 585 931 B1

**EP 4 585 931 B1**

**REFERENCES CITED IN THE DESCRIPTION**

**Patent documents cited in the description**

- CN 212483673 U

- WO 2023029598 A1